# EUROPEAN PATENT APPLICATION

(11) **EP 4 664 516 A2**
(43) Date of publication of application: **17.12.2025**
(21) Application number: 25180192.4
(22) Date of filing: 02.06.2025
(51) Int. Cl.: H01L 23/13, H01L 23/00

(54) **PACKAGED SEMICONDUCTOR DEVICE AND METHOD FOR PACKAGING**

(30) Priority: 14.06.2024 CN 202410766717
(71) Applicant: NXP USA, Inc., Austin, TX 78735 (US)
(72) Inventor: Ge, You, 5656AG Eindhoven (NL); Wang, Zhijie, 5656AG Eindhoven (NL); Lee, Yit Meng, 5656AG Eindhoven (NL)
(74) Representative: Colaiuda, Antonella

(57) **Abstract**

A packaged semiconductor device includes a device die, at least one device contact, a substrate, and at least one substrate contact. The device die has a first device side and a second device side opposite to the first device side. The at least one device contact is arranged on the first device side of the device die. The substrate has a first substrate side and a second substrate side opposite to the first substrate side. The at least one substrate contact is arranged on the first substrate side of the substrate. The device die is attached to the substrate with the first device side facing the first substrate side. The at least one device contact is in direct contact with a corresponding one of the at least one substrate contact. Either or both of the at least one device contact and the at least one substrate contact are elastic.

## Description

### BACKGROUND

The present disclosure relates to a packaged semiconductor device, and a method for packaging a semiconductor device.

Flip-chip is a technology used in packaging semiconductor devices. Solder bumps are formed on a side surface of a device die on which the contact pads are already formed in previous wafer processes. The device die is attached to a substrate at the side surface on which the solder bumps are formed, such that the solder bumps are aligned with corresponding contact pads on the substrate. Usually, a reflow process follows to electrically join the solder bumps on the semiconductor die and the aligned contact pads on the substrate together. The resulting connections from the reflow process between the device die and the substrate are vulnerable, because the reliabilities of the connections are hard to control. Moreover, going through the high temperature environment of the reflow process may harm the device die.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In one embodiment, a packaged semiconductor device includes a device die, at least one device contact, a substrate, and at least one substrate contact. The device die has a first device side and a second device side opposite to the first device side. The at least one device contact is arranged on the first device side of the device die. The substrate has a first substrate side and a second substrate side opposite to the first substrate side. The at least one substrate contact is arranged on the first substrate side of the substrate. The device die is attached to the substrate with the first device side facing the first substrate side. The at least one device contact is in direct contact with a corresponding one of the at least one substrate contact. Either or both of the at least one device contact and the at least one substrate contact are elastic.

In one or more embodiments, the at least one substrate contact has a profile conformal a profile of a corresponding one of the at least one device contact.

In one or more embodiments, the profile of the at least one substrate contact is concave, for receiving the corresponding one of the at least one device contact.

In one or more embodiments, the at least one substrate contact is characterized as at least one cavity, the at least one cavity has an aperture diameter at the first substrate side of the substrate, and an inner diameter further from the first substrate side along a thickness direction of the substrate, and wherein the inner diameter is larger than the aperture diameter such that the cavity has a bottleneck on the first substrate side of the substrate.

In one or more embodiments, the substrate includes: at least one electrically conductive layer on an inner surface of the respective at least one cavity; and re-distribution layers arranged between the first substrate side and the second substrate side, and electrically conductive to the at least one electrically conductive layer and substrate pads on the second substrate side. The at least one electrically conductive layer of the substrate is in contact with the aligned at least one device contact such that the at least one device contact is electrically conductive to a corresponding one of the substrate pads on the second substrate side of the substrate by way of the respective at least one electrically conductive layer and the respective re-distribution layer.

In one or more embodiments, the at least one device contact protrudes from the first device side of the device die, and has a first portion with a first diameter and connected to the first device side of the device die, and a second portion with a second diameter and arranged on a side of the first portion opposite to the first device side, the second diameter is larger than the first diameter and the aperture diameter of the corresponding at least one cavity, such that the at least one device contact is received in the corresponding one of the at least one cavity through deforming the second portion.

In one or more embodiments, the at least one substrate contact protrudes from the first substrate side of the substrate; the at least one device contact protrudes from the first device side of the device die; the at least one device contact is in direct contact with the corresponding one of the at least one substrate contact by deforming the elastic either or both of the at least one device contact and the at least one substrate contact.

In one or more embodiments, the substrate further has one or more locking cavities each having an aperture diameter at the first substrate side of the substrate, and an inner diameter further from the first substrate side along a thickness direction of the substrate, and wherein the inner diameter is larger than the aperture diameter such that each of the one or more locking cavities has a bottleneck on the first substrate side of the substrate. The packaged semiconductor device further includes one or more locking protrusions protruding from the first device side of the device die, each of the one or more locking protrusions is aligned with and received in a corresponding one of the one or more locking cavities; wherein each of the one or more locking protrusions has a first portion with a first diameter and connected the first device side of the device die, and a second portion with a second diameter and arranged on a side of the first portion opposite to the first device side, the second diameter is larger than the first diameter and the aperture diameter of the corresponding locking cavity, such that the locking protrusion is received in the corresponding one of the one or more locking cavities through deforming the second portion.

In one or more embodiments, the one or more locking protrusions are one or more of the at least one device contact.

In one or more embodiments, the at least one device contact includes conductive polymer.

In one or more embodiments, the conductive polymer includes doped graphene, and a material selected from a group consisting of: polyethylene terephthalate and polyvinyl alcohol.

In one or more embodiments, the conductive polymer includes the graphene with a doping concentration of at least 3% by volume.

In another embodiment, there is a method for packaging a semiconductor device. The semiconductor device includes a device die, at least one device contact, a substrate, and at least one substrate contact. The device die has a first device side and a second device side opposite to the first device side. The at least one device contact is arranged on the first device side of the device die. The substrate has a first substrate side and a second substrate side opposite to the first substrate side. The at least one substrate contact is arranged on the first substrate side of the substrate. Either or both of the at least one device contact and the at least one substrate contact being elastic. The method includes attaching the device die to the substrate by: facing the first device side of the device die to the first substrate side of the substrate; aligning the at least one device contact with a corresponding one of the at least one substrate contact; and directly contacting the at least one device contact with the corresponding one of the at least one substrate contact.

In one or more embodiments, the method further includes: forming the at least one substrate contact on the first substrate side of the substrate to have a first profile; and forming the at least one device contact on the first device side of the device die to have a second profile conformal the first profile of the at least one substrate contact.

In one or more embodiments, forming the at least one substrate contact on the first substrate side of the substrate to have a first profile includes forming the at least one substrate contact with a concave profile for receiving the corresponding one of the at least one device contact.

In one or more embodiments, forming the at least one substrate contact on the first substrate side of the substrate includes etching the first substrate side of the substrate to form at least one cavity each having: an aperture diameter near the first substrate side of the substrate; an inner diameter further the first substrate side along a thickness direction of the substrate, the inner diameter is larger than the aperture diameter such that the cavity has a bottleneck on the first substrate side of the substrate.

In one or more embodiments, the substrate includes one or more re-distribution layers arranged between the first substrate side and the second substrate side. The method further includes forming at least one electrically conductive layer on an inner surface of the respective at least one cavity such that the at least one electrically conductive layer is electrically connected to the one or more re-distribution layers and substrate pads on the second substrate side.

In one or more embodiments, forming the at least one device contact on the first device side of the device die includes forming the at least one device contact protruding from the first device side of the device die, the at least one device contact has a first portion with a first diameter and connected to the first device side of the device die, and a second portion with a second diameter and arranged on a side of the first portion opposite to the first device side, the second diameter is larger than the first diameter and the aperture diameter of the corresponding at least one cavity. Directly contacting the at least one device contact with the corresponding one of the at least one substrate contact includes receiving the at least one device contact in the corresponding one of the at least one cavity by deforming the second portion of the at least one device contact.

In one or more embodiments, the method further includes: forming the at least one substrate contact on the first substrate side of the substrate to protrude from the first substrate side; and forming the at least one device contact on the first device side of the device die to protrude from the first device side. Directly contacting the at least one device contact with the corresponding one of the at least one substrate contact includes deforming the elastic either or both of the at least one device contact and the at least one substrate contact.

In one or more embodiments, the method further includes: in the substrate, forming one or more locking cavities each having an aperture diameter near the first substrate side of the substrate, and an inner diameter further the first substrate side along a thickness direction of the substrate, the inner diameter being larger than the aperture diameter such that each of the one or more locking cavities has a bottleneck on the first substrate side of the substrate; on the first device side of the device die, forming one or more locking protrusions protruding from the first device side of the device die; wherein each of the one or more locking protrusions has a first portion with a first diameter and connected the first device side of the device die, and a second portion with a second diameter and arranged on a side of the first portion opposite to the first device side, the second diameter being larger than each of the first diameter and the aperture diameter of the corresponding locking cavity; aligning each of the one or more locking protrusions with a corresponding one of the one or more locking cavities; and receiving each of the one or more locking protrusion in the corresponding one of the one or more locking cavities by deforming the second portion.

In one or more embodiments, forming the at least one device contact on the first device side of the device die includes forming the one or more locking protrusions.

In one or more embodiments, the at least one device contact includes conductive polymer.

In one or more embodiments, the conductive polymer includes doped graphene, and a material selected from a group consisting of polyethylene terephthalate and polyvinyl alcohol.

In one or more embodiments, the conductive polymer includes at least 3% by volume of graphene.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
Fig. 1 is an exploded perspective view of a semiconductor device die and a substrate for packaging the semiconductor device according to an embodiment;
Fig. 2 is a flipped view of the device die 102 of Fig. 1;
Fig. 3 is a partial cross-sectional view of the semiconductor device according to an embodiment;
Fig. 4 shows partial cross-sectional views of the semiconductor device of Fig. 3 during and after assembling and attaching the device die 302 to the substrate 304;
Fig. 5 is a partial cross-sectional view of a semiconductor device according to another embodiment;
Fig. 6 shows partial cross-sectional views of the device die and the device contact in processes for forming the device contacts;
Fig. 7 are partial cross-sectional views of the substrate and the substrate contact in processes for forming the substrate contacts; and
Fig. 8 is a partial and cross-sectional view of the semiconductor device according to another embodiment.

### DETAILED DESCRIPTION

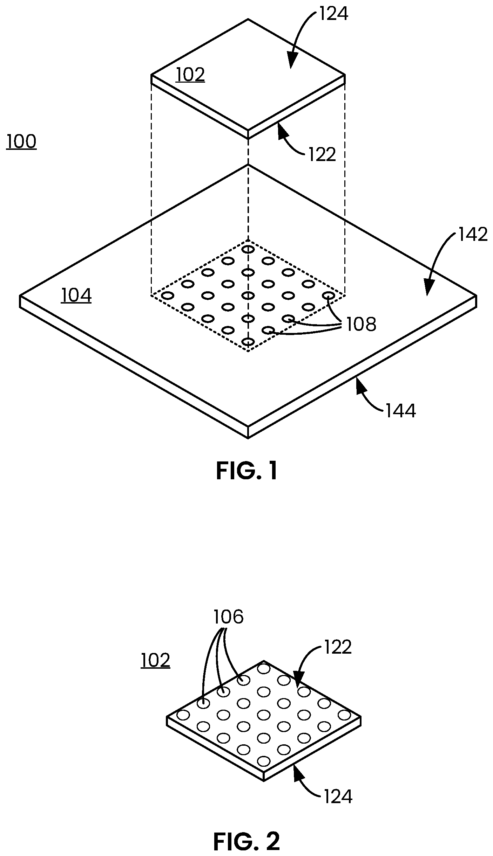

Fig. 1 is an exploded perspective view of a semiconductor device die and a substrate for packaging the semiconductor device according to an embodiment. In the exploded view of the semiconductor device 100, there includes a device die 102 and a substrate 104. The device die 102 has a first device side 122 and a second device side 124 opposite to the first device side 122. The substrate 104 has a first substrate side 142 and a second substrate side 144 opposite to the first substrate side 142. In the final packaged semiconductor device, the device die 102 is attached to the substrate 104, with the first device side 122 facing the first substrate side 142.

With reference to Fig. 2 which is a flipped view of the device die 102 of Fig. 1, the semiconductor device 100 further includes at least one device contact 106 arranged on the first device side 122 of the device die 102. Correspondingly, the semiconductor device 100 includes at least one substrate contact 108 arranged on the first substrate side 142 of the substrate 104. As described above, in the final packaged semiconductor device, the device die 102 is attached to the substrate 104, with the first device side 122 facing the first substrate side 142, and the at least one device contact 106 aligned with and in direct contact with a corresponding one of the at least one substrate contact 108. By "in direct contact", it means the device contact 106 and the corresponding substrate contact 108 are in direct contact over a large fraction, for example more than 50%, of their surface areas. In the example, for the aforementioned direct contact, the at least one device contact 106 and the at least one substrate contact 108 have conformal profiles. For example, if the device contact 106 is configured to have a convex profile, the corresponding substrate contact 108 is configured to have a concave profile for receiving the protrusion of the device contact 106, and *vice versa.*

Either or both of the at least one device contact 106 and the at least one substrate contact 108 is elastic. That is to say, in a pair of the device contact 106 and the substrate contact 108 that are mutually contacting each other, either or both in the pair is elastic. For being elastic and conductive, the material used for forming either or both of the at least one device contact 106 and the at least one substrate contact 108 is conductive polymer. For example, the material may be polyethylene terephthalate (PET) or polyvinyl alcohol (PVA), and doped with graphene with a doping concentration of at least 3% by volume.

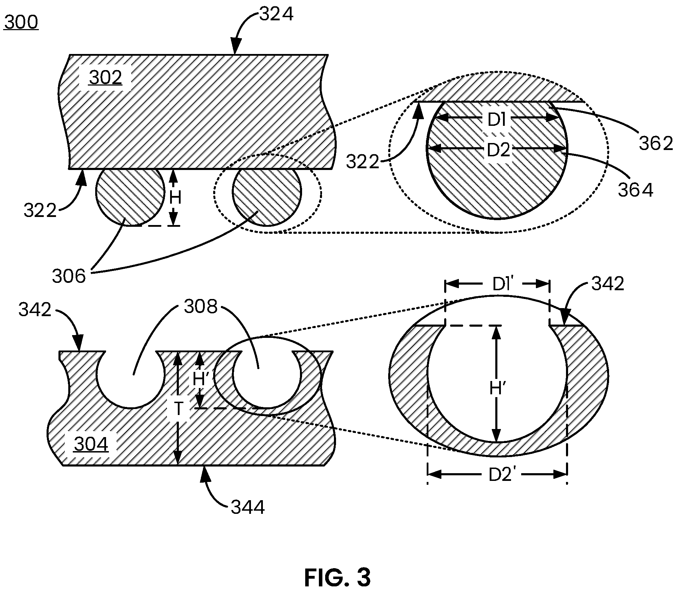

Referring now to Fig. 3, this shows a partial cross-sectional view of the semiconductor device according to an embodiment, with the device die and the substrate separated apart from each for easily describing the structure. A device die 302 of the semiconductor device 300 has a first device side 322 and a second device side 324 opposite to the first device side 322. A device contact 306 is arranged as protruding from the first device side 322 of the device die 302, configured as a part of a sphere or an oblate sphere, and more specifically, more than a hemisphere. In the enlarged view of the device contact 306, there includes a first portion 362 which connects to the first device side 322 of the device die 302, and a second portion 364 on a side of the first portion 362 opposite to the first device side 322. The first portion 362 has a first diameter D1, and the second portion 364 has a second diameter D2 which is larger than the first diameter D1. In a non-limiting example, the second diameter D2 is 10 microns (10µm), and a distance between centres of neighboring device contacts 306, also referred to as an "I/O pitch", is 20µm.

The substrate 304 of the semiconductor device 300 has a first substrate side 342 and a second substrate side 344 opposite to the first substrate side 342. In the example of Fig. 3, the substrate contact is implemented as a cavity 308 formed in the substrate 304, and thus forms part of the substrate 304. The cavity 308 has an aperture diameter D1' near the first substrate side 342 of the substrate 304, and an inner diameter D2' further from the first substrate side 342 along a thickness direction T of the substrate 304. The inner diameter D2' is larger than the aperture diameter D1', thereby the cavity 308 has a bottleneck on the first substrate side 342 of the substrate 304. As described above, the device contact and the corresponding substrate contact have mating profiles. In the example of Fig. 3, the cavity 308 has a partial sphere profile similar to that of the device contact 306, with similar dimensions in configuration. For example, the aperture diameter D1' of the cavity 308 is approximately equal to the first diameter D1 of the first portion 362 of the device contact 306, and the inner diameter D2' of the cavity 308 is approximately equal to the second diameter D2 of the second portion 364 of the device contact 306. In addition, a height H that the device contact 306 protrudes from the first device side 322 of the device die 302 is approximately equal to a depth H' that the cavity 308 penetrates into the substrate 304 from the first substrate side 342. The height H and the depth H' are comparable to the diameter of the sphere of the device contact and, according to an example, are around 10µm.

The device contact 306 is formed of elastic and conductive materials, as described above. Arranged on and connected to the first device side 322 of the device die 302, the device contact 306 is connective to, or coupled to, circuits and blocks internal to the device die 302. For finalizing a packaged semiconductor device 300, the device die 302 and the substrate 304 are placed in alignment, with the first device side 322 facing the first substrate side 342, and the device contact 306 aligned with a corresponding one of the cavity 308. A force is applied to cause the device die 302 and the substrate 304 to move towards each other, and cause the device contact 306 to be received into the corresponding cavity 308. Because of the bottleneck of the cavities 308, the second portion 364 of the elastic device contact 306 is deformed when passing through the aperture diameter D1' of the cavity 308. The extent to which the deformation is relaxed once the device contact 306 is mated with the aperture will be considered in more detail hereinbelow.

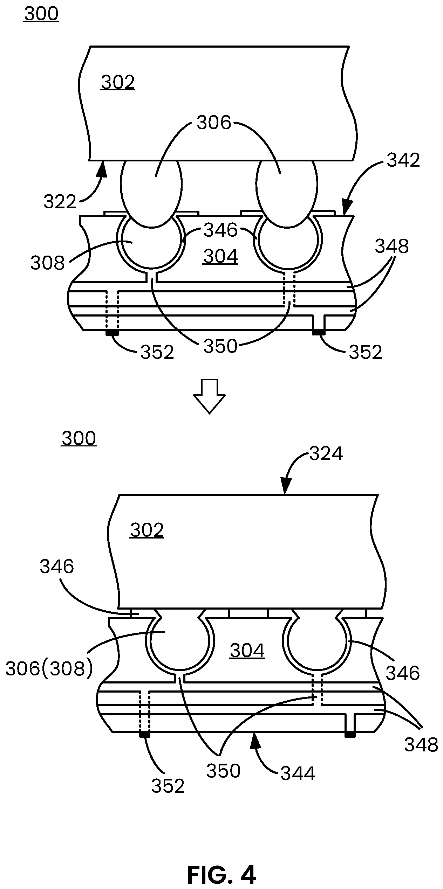

Fig. 4, which shows partial cross-sectional views of the semiconductor device of Fig. 3 during and after assembling and attaching the device die 302 to the substrate 304. In addition to those illustrated in Fig. 3, the substrate 304 further includes, shown in Fig. 4, on an inner surface of the cavity 308, an electrically conductive layer 346. The electrically conductive layer 346 also extends across the aperture of the cavity 308 to the first substrate side 342 for a limited distance. A thickness of the electrically conductive layer 346 is approximately one or more microns, for example in a range of 1-3µm. The substrate 304 further includes one or more re-distribution layers (RDLs) 348 sandwiched between the first substrate side 342 and the second substrate side 344. The RDL 348 is electrically connected to one or more corresponding electrically conductive layers 346 through vias 350. The RDLs 348 are also electrically connected to one or more corresponding substrate pads 352 on the second substrate side 344 of the substrate 304. After attaching the device die 302 to the substrate 304 and receiving the device contact 306 into the cavity 308, the electrically conductive layer 346 of the substrate 304 is in contact with the device contact 306, thereby an electrical connection is established from the device die 302 to the substrate pad 352, by way of the elastic and conductive device contact 306, the contacting electrically conductive layer 346, and the RDL 348. In various examples, the substrate 304 may be a laminated board with molded substrates. In other examples, the substrate 304 may be another device die, and the packaged semiconductor device may accordingly be a multi-chip package. Although the example of Fig. 4 shows the substrate 304 as including the substrate pads 352, in other examples, the connecting means on the second substrate side 344 may be a ball-grid, pins, etc.

With the interference fit joint between the device contact 306 and the cavity 308, the device die 302 and the substrate 304 are firmly locked with each other. In various embodiments, the device contact may be configured as cavities and similar to the cavities of Fig. 3 and Fig. 4, and the substrate contact may accordingly be configured as bulb-shaped and similar to the device contacts of Fig. 3 and Fig. 4.

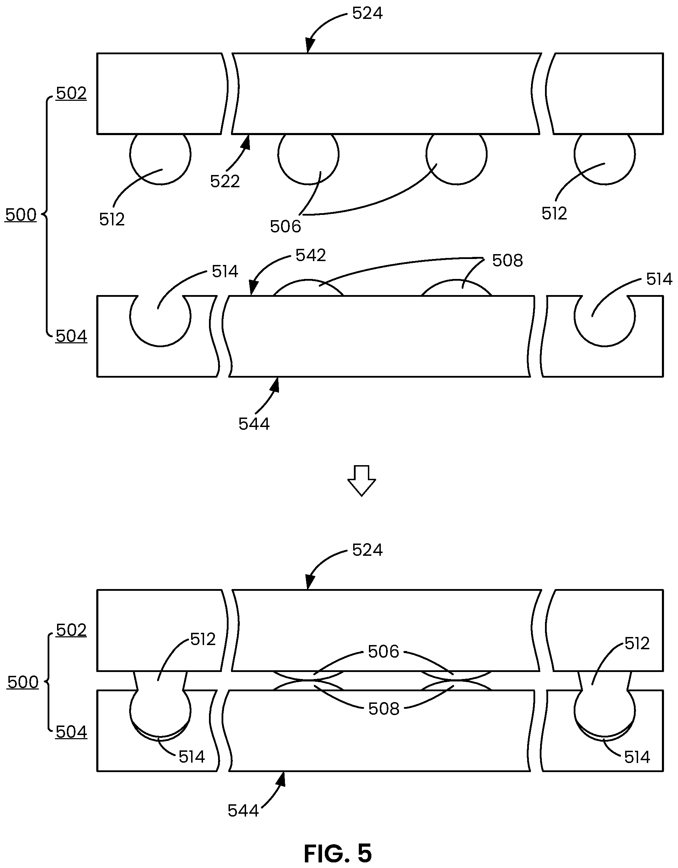

Fig. 5 is a partial cross-sectional view of a semiconductor device according to another embodiment. The semiconductor device 500 includes the device die 502 having the first device side 522 and the second device side 524, the substrate 504 having the first substrate side 542 and the second substrate side 544, one or more device contacts 506 arranged on the first device side 522, and one or more substrate contacts 508 arranged on the first substrate side 542. The device contacts 506 of the embodiment of Fig. 5 are similar to the device contacts 306 of the embodiment of Fig. 3 and Fig. 4, configured as protruding from the first device side 522 of the device die 502. The substrate contacts 508 of the embodiment of Fig. 5, however, are different from the substrate contacts 308 of the embodiment of Fig. 3 and Fig. 4. The substrate contacts 508 are configured as having a convex profile and protruding from the first substrate side 542 of the substrate 504. The detailed structure of the substrate 504, for example the substrate pads and the RDLs as have been described above, are not shown in Fig. 5. However it is understood that the substrate contacts 508 are connected to the RDLs and corresponding substrate pads through vias inside the substrate 504, similar to that have been described above. In the example of Fig. 5, the height of the substrate contact 508 is less than the height of the device contact 506.

As described, either or both of the at least one device contact 506 and the at least one substrate contact 508 are elastic, as the device die 502 is attached to the substrate 504, the device contact 506 is in direct contact with the corresponding substrate contact 508, and either or both of the device contact 506 and the substrate contact 508 are deformed. Similarly, the elastic either or both of the device contact 506 and the substrate contact 508 are formed of conductive polymer materials.

The semiconductor device 500 of Fig. 5 further includes one or more locking protrusions 512 arranged on and protruding from the first device side 522 of the device die 502. Correspondingly, one or more locking cavities 514 are configured in the substrate 504. The locking protrusions 512 are similar to the device contacts 306 of Fig. 3 and Fig. 4, and the locking cavities 514 are also similar to the cavities 308 of Fig. 3 and Fig. 4. In assembling the packaged semiconductor device 500, each locking protrusion 512 is received in a corresponding locking cavity 514, by deforming the portion of the locking protrusion 512 which has the diameter larger than the aperture diameter of the locking cavity 514. It is understood that, by receiving the locking protrusions 512 in the locking cavities 514, the first device side 522 is very close to, and urged towards, the first substrate side 542, and the device contacts 506 and the substrate contacts 508 therebetween press each other and deform. The device contacts 506 and the substrate contacts 508 are configured to have enough elasticity, in order to be deformed adequately when the first device side 522 and the first substrate side 542 become directly contacting each other. In other examples, the device contacts 506 and the substrate contacts 508 may be formed as having reduced heights in an undeformed state.

In one or more embodiments, the device contacts are arranged in an array, and correspondingly, the substrate contacts are also arranged in an array. In an example, the semiconductor device includes hundreds of, or up to more than a thousand device contacts arranged in the array. As described above, both the device contacts 506 and the locking protrusions 512 are similar to the device contacts 306 of Fig. 3 and Fig. 4, and accordingly, the locking protrusions 512 and the device contacts 506 may be arranged on the first device side 522 simultaneously in a single manufacturing process. In some examples, the locking protrusions 512 are selected ones of the device contacts 506, for example peripheral one or more rows of the device contacts 506 in the array. However, in other examples, the locking protrusions 512 can be different selected ones of the device contacts 506, or can be formed in a process different from the process in which the device contacts 506 are formed. Moreover, the locking protrusions 512 and the corresponding locking cavities 514 may be arranged with their locations interchanged, or may be arranged in other configurations, such that a locking force is produced between the device die 502 and the substrate 504 to force the elastic ones of either or both of the device contact and the substrate contact to deform, thereby directly contacting each other. Because of the deformation of the elastic material, the device contact 506 and substrate contact 508 are urged into contact over a larger fraction (typically more than 50%) of their mating surfaces, and thus may be described as being in close or intimate contact.

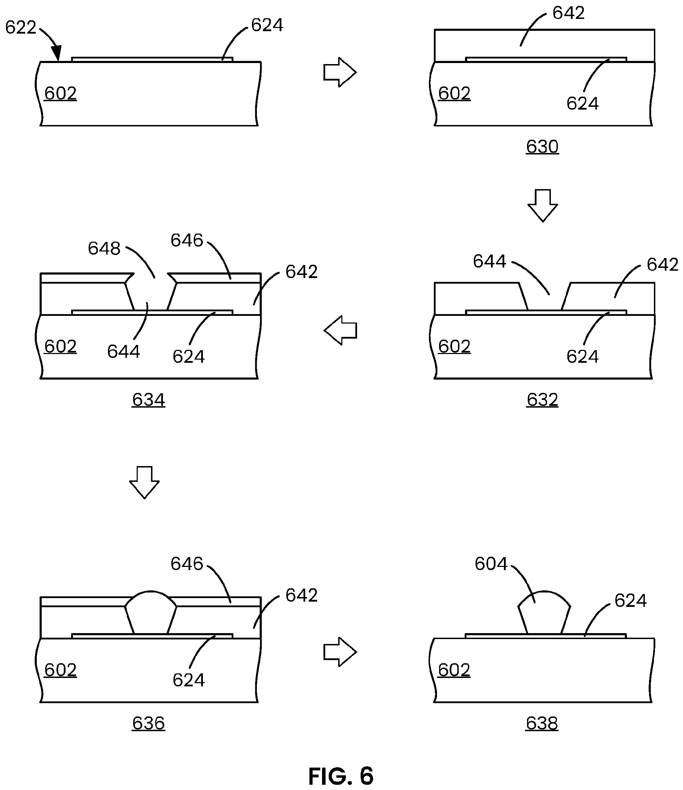

Fig. 6 shows partial cross-sectional views of the device die and the device contact at various stages of a process for forming the device contacts. The device die 602 has a first device side 622 on which one or more die pads 624 are arranged. The one or more die pads 624 may be arranged in an array on the first device side 622, and at least some of them are connected to circuits and/or blocks internal the device die 602. In an example, the die pads 624 are formed by chromium (Cr), copper (Cu), or other applicable metals or alloys. The die pads 624 may be formed by: forming a layer on the die surface by a process of forming under bumping metal layers (UBM layers) using existing bumping technologies, and etching the layer to retain the die pads. The device contacts 604 are manufactured on the first device side 622 through photolithography, and will now be described in more detail.

In step 630, a photo-resist (PR) layer 642 is applied on the first device side 622 of the device die 602. In the example, the PR layer 642 has a thickness of around 6 microns. In step 632, the PR layer 642 is patterned, with part of the PR layer 642 being removed until the die pad 624 underneath is exposed. It is understood that, with a typical photolithography technology, for example negative photolithography or positive photolithography, the PR layer 642 is patterned through applying a photomask (not shown) onto the PR layer 642, exposing the PR layer 642 and the photomask under light so that the part of the PR layer 642 not covered by photomask undergoes a chemical change, and removing the part of PR layer 642 that had the chemical change to expose the part of the die pad 624 underneath. Removal of the part of the PR layer 642 leaves an opening 644 in the PR layer 642. Because the light is applied onto the PR layer 642 in a direction targeting the first device side 622, the top surface of the PR layer 642 receives more emission of light than the bottom surface which connects with the die pad 624, and more of the PR layer 642 on the top surface will be removed than the PR layer 642 at the bottom surface. This means, as can be seen from Fig. 6, the opening 644 in the PR layer 642 is wider at locations on the top surface than that at locations near the die pad 624. With reference to the device contacts 306 of Fig. 3 and Fig. 4, the opening 644 has a size of around 10µm at locations on the top surface, corresponding to the diameter D2 of the device contact 306.

In step 634, a stencil 646 is placed over the patterned PR layer 642. Specifically, the stencil 646 is already patterned before being placed over the PR layer 642. The stencil 646 is patterned through laser etching. The resulting openings 648 in the stencil 646 are aligned with the openings 644 in the patterned PR layer 642. In more details, the opening 648 is wider at the bottom, and is narrower on the top. The stencil 646 with the openings 648 such configured act as a conformal layer for forming a bulb-shaped device contact 604. By aligning the opening 644 in the PR layer 642 and the opening 648 in the stencil 646, the openings combine as a cavity. In the example, the stencil 646 has a thickness of around 4µm, such that the combined cavity has a depth which is approximately equal to the height of the device contact 604. In step 636, conductive polymer materials are dripped into the cavity. As described above, the conductive polymer can be PET or PVA doped with graphene at a concentration of 3% by volume. The conductive polymer fills in the cavity deep until the die pad 624, and connects with the die pad 624. Finally, after the conductive polymer cures, the stencil 646 and the PR layer 642 are both removed in step 638. The conductive polymer in the cavity is left on the first device side 622 of the device die 602, and is electrically connected to the die pad 624, acting as the device contact 604 for subsequent assembling with the substrate as described above.

The shape of the device contact 604 is generally defined by the photoresist, the stencil 646, and material properties during the deposition or dripping process. In one or more embodiments, the shape of the device contact 604 is an inverted pear shape, having a generally hemispherical, or oblate spheroid top portion, which is connected to the device die 602 by a prolate, or elongate, spheroid, lower portion.

The substrate contacts 508 of Fig. 5 may be similarly formed through the process of Fig. 6. However, in other examples where the device contacts 506 are already formed by conductive polymer, the substrate contacts 508 may be formed by simply dripping the conductive polymer onto corresponding locations on the substrate 504, or by other conductive materials such as metal and through applicable processes.

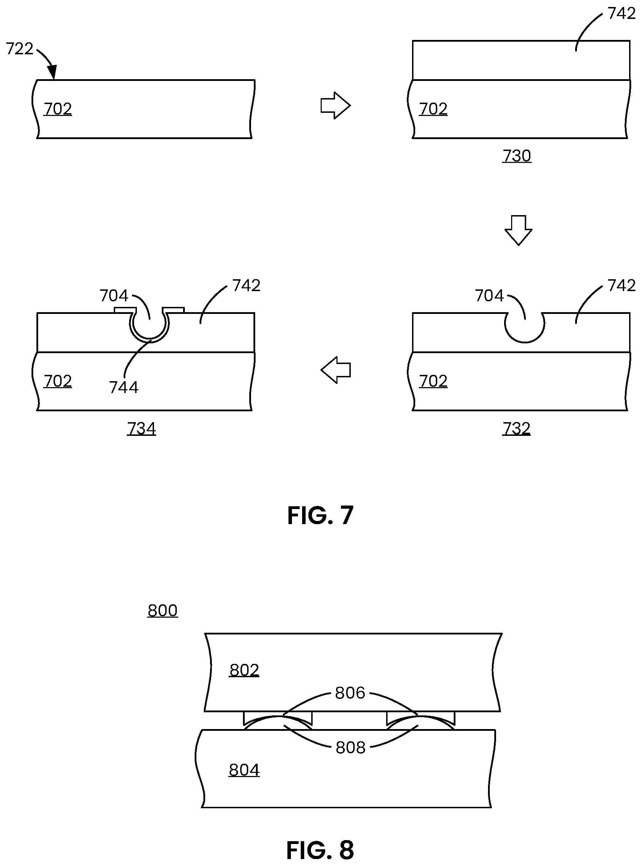

Fig. 7 shows partial cross-sectional views of the substrate and the substrate contact in processes for forming the substrate contacts. The substrate 702 has a first substrate side 722 on which the one or more substrate contacts 704 are to be arranged. The substrate contacts 704 in this example are implemented as cavities similar to the cavities 308 of Fig. 3. In step 730, polyimide (PI) materials 742 are coated on the first substrate side 722 of the substrate 702. The PI layer 742 may have a thickness of more than 10µm, for example 13-15µm. In step 732, the PI layer 742 is applied an etching process to form the cavities 704. Specifically, a patterned isotropic wet etching is applied to the PI layer 742, resulting in an inner diameter of the cavity 704 inside the substrate 702 being larger than an aperture diameter at locations on the first substrate side 722. The isotropic wet etching is applied to the PI layer 742 until the resulting cavity 704 has a depth of around 10µm which is almost equal to the height of the device contact 604 of Fig. 6. However, in other examples, the PI layer 742 is etched through other processes, for example photolithography which is similar to what have been described hereinabove. In step 734, a metal layer 744 is applied on the inner surface of the cavity 704. The metal layer 744 may be applied through electroplating or sputtering FeNi or Cu materials onto the inner surface of the cavity. The metal layer 744 also extends across the aperture of the cavity 704 to a specific distance on the first substrate side 722.

As described above, the process of Fig. 6 for forming the bulb-shaped device contact and the process of Fig. 7 for forming the cavity may also be used for forming the locking protrusions and locking cavities of Fig. 5. Also, the device contacts 506 and substrate contacts 508 both having the protruding profiles may be formed through the process of Fig. 6. As described, in packaging the semiconductor device, the elastic ones of either or both of the device contact and the substrate contact are deformed, to directly contact each other. The resulting semiconductor device does not require the wafering bumping process of the existing flip-chip packaging process, and avoids a requirement for reflow process for the wafer bump to connect to UBM layers on the substrate. As can be understood, wafer bumping and reflow processes typically impose restrictions on levels of moisture, pitch densities etc. For example, MSL-1 (moisture sensitivity level 1) limits the time duration during which wafers and substrates may be exposed to an open environment, to avoid "popcorn" issues during reflow due to overly absorbed moisture from the air. By packaging the semiconductor device without the reflow process, the restrictions can be reduced or eliminated. In addition, due to the solder bridge risk in the reflow process, there are requirements to keep the pitch distance amongst wafer bumps large enough, for example larger than 0.3mm, to avoid solder bridging, and accordingly the I/O density is low. With alternative fine-pitch bump technologies, the size of bumps are able to be shrunk to 50 microns (50µm), and the bump pitch is as small as 100µm, but the cost of the fine-pitch bumping technology increases significantly. Moreover, solder joints resulting from the reflow process can be vulnerable and easy to crack/open. The embodiments described above do not require a reflow process in packaging the semiconductor device, and according may achieve a high density of I/O. As a result, degree of difficulty in manufacturing the packaged semiconductor device may be lowered.

Fig. 8 shows, in part, a cross-sectional view of a semiconductor device according to another embodiment. The semiconductor device 800 includes a device die 802 and a substrate 804 that are attached together. Device contacts 806 are arranged on a side of the device die 802 and facing the substrate 804. Correspondingly, substrate contacts 808 are arranged on a side of the substrate 804 and facing the device die 802. The device contacts 806 are configured to have a concave profile. The substrate contacts 808 are configured to have a convex profile, seen as protruding from the substrate 804 towards the device die 802. In attaching the device die 802 to the substrate 804, the substrate contact 808 is aligned with a corresponding one of the device contact 806, and closely and directly contacts the device contact 806. Because the device contact 806 has the concave profile, the substrate contact 808 is received in the recessed portion of the device contact 806, with the elastic ones of either or both of the device contact 806 and the substrate contact 808 being deformed due to the tight contact between each other. Because of the sloped surface of the device contact 806 facing the substrate contact 808, in attaching the device die 802 to the substrate 804, the substrate contact 808 may slip to the arc top of the device contact 806, thereby the device die 802 and the substrate 804 of the semiconductor device 800 are self-aligned. For locking the device die 802 and the substrate 804 together, the interference fit joints as described with reference to the examples above may be employed, and may be arranged on peripheral areas of the device die 802.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A packaged semiconductor device comprising:
a device die having a first device side and a second device side opposite to the first device side;
at least one device contact arranged on the first device side of the device die;
a substrate having a first substrate side and a second substrate side opposite to the first substrate side; and
at least one substrate contact arranged on the first substrate side of the substrate; wherein
the device die is attached to the substrate with the first device side facing the first substrate side;
the at least one device contact is in direct contact with a corresponding one of the at least one substrate contact; and
either or both of the at least one device contact and the at least one substrate contact are elastic.

2. The packaged semiconductor device of claim 1, wherein the at least one substrate contact has a profile conformal a profile of a corresponding one of the at least one device contact.

3. The packaged semiconductor device of claim 2, wherein the profile of the at least one substrate contact is concave, for receiving the corresponding one of the at least one device contact.

4. The packaged semiconductor device of claim 1 or claim 2, wherein the at least one substrate contact is characterized as at least one cavity, the at least one cavity has an aperture diameter at the first substrate side of the substrate, and an inner diameter further from the first substrate side along a thickness direction of the substrate, and wherein the inner diameter is larger than the aperture diameter such that the cavity has a bottleneck on the first substrate side of the substrate.

5. The packaged semiconductor device according to any preceding claim, wherein the substrate comprises:
at least one electrically conductive layer on an inner surface of the respective at least one cavity; and
re-distribution layers arranged between the first substrate side and the second substrate side, and electrically conductive to the at least one electrically conductive layer and substrate pads on the second substrate side;
wherein the at least one electrically conductive layer of the substrate is in contact with the aligned at least one device contact such that the at least one device contact is electrically conductive to a corresponding one of the substrate pads on the second substrate side of the substrate by way of the respective at least one electrically conductive layer and the respective re-distribution layer.

6. The packaged semiconductor device according to any preceding claim, wherein the at least one device contact protrudes from the first device side of the device die, and has a first portion with a first diameter and connected to the first device side of the device die, and a second portion with a second diameter and arranged on a side of the first portion opposite to the first device side, the second diameter is larger than the first diameter and the aperture diameter of the corresponding at least one cavity, such that the at least one device contact is received in the corresponding one of the at least one cavity through deforming the second portion.

7. The packaged semiconductor device according to any preceding claim, wherein
the at least one substrate contact protrudes from the first substrate side of the substrate;
the at least one device contact protrudes from the first device side of the device die;
the at least one device contact is in direct contact with the corresponding one of the at least one substrate contact by deforming the elastic either or both of the at least one device contact and the at least one substrate contact.

8. The packaged semiconductor device according to any preceding claim, wherein the at least one device contact comprises conductive polymer.

9. The packaged semiconductor device of claim 8, wherein the conductive polymer comprises doped graphene, and a material selected from a group consisting of: polyethylene terephthalate and polyvinyl alcohol.

10. The packaged semiconductor device of claim 8 or claim 9, wherein the conductive polymer comprises the graphene with a doping concentration of at least 3% by volume.

11. A method for packaging a semiconductor device comprising a device die, at least one device contact, a substrate, and at least one substrate contact; the device die having a first device side and a second device side opposite to the first device side, the at least one device contact being arranged on the first device side of the device die, the substrate having a first substrate side and a second substrate side opposite to the first substrate side, the at least one substrate contact being arranged on the first substrate side of the substrate, and either or both of the at least one device contact and the at least one substrate contact being elastic; wherein the method comprises attaching the device die to the substrate by:
facing the first device side of the device die to the first substrate side of the substrate;
aligning the at least one device contact with a corresponding one of the at least one substrate contact; and
directly contacting the at least one device contact with the corresponding one of the at least one substrate contact.

12. The method of claim 11, further comprising:
forming the at least one substrate contact on the first substrate side of the substrate to have a first profile; and
forming the at least one device contact on the first device side of the device die to have a second profile conformal the first profile of the at least one substrate contact.

13. The method of claim 12, wherein forming the at least one substrate contact on the first substrate side of the substrate to have a first profile comprises forming the at least one substrate contact with a concave profile for receiving the corresponding one of the at least one device contact.

14. The method of claim 12, wherein forming the at least one substrate contact on the first substrate side of the substrate comprises etching the first substrate side of the substrate to form at least one cavity each having:
an aperture diameter near the first substrate side of the substrate;
an inner diameter further the first substrate side along a thickness direction of the substrate, the inner diameter is larger than the aperture diameter such that the cavity has a bottleneck on the first substrate side of the substrate.

15. The method of claim 14, wherein the substrate comprises one or more re-distribution layers arranged between the first substrate side and the second substrate side; and the method further comprises forming at least one electrically conductive layer on an inner surface of the respective at least one cavity such that the at least one electrically conductive layer is electrically connected to the one or more re-distribution layers and substrate pads on the second substrate side.
